# EUROPÄISCHE PATENTANMELDUNG

(11) **EP 3 629 041 A1**
(43) Veröffentlichungstag der Anmeldung: **01.04.2020**
(21) Anmeldenummer: 18197403.1
(22) Anmeldetag: 28.09.2018
(51) Int. Cl.: G01R 31/42, G01R 31/28, G01R 19/165

(54) **VERFAHREN UND ANORDNUNG ZUM DURCHFÜHREN EINES ABSCHALTTESTS AN EINEM WECHSELRICHTER**

(71) Anmelder: FRONIUS INTERNATIONAL GmbH, 4643 Pettenbach (AT)
(72) Erfinder: Danmayr, Joachim, 4643 Pettenbach (AT); Kasberger, Christian, 4643 Pettenbach (AT)
(74) Vertreter: Patentanwälte Pinter & Weiss OG

(57) **Zusammenfassung**

Um mit geringem Aufwand einen Abschalttest an einem Wechselrichter (1) durchführen zu können ist vorgesehen, dass zu einem ersten Zeitpunkt (t_{T}) ein Triggersignal (TS) auf den Wechselstrom (I_{AC}) oder die Wechselspannung (V_{AC}) aufmoduliert wird, mit dem Wechselrichter (1) an einem zweiten Zeitpunkt (t_{F}) eine definierte Zeitdauer (t_{D}) nach dem Beginn des Triggersignals (TS) mit dem Wechselrichter (1) ein Wechselstrom (I_{AC}) oder eine Wechselspannung (V_{AC}) mit einem Fehlersignal (FS) erzeugt wird, das vom Wechselrichter (1) erkannt wird und eine Abschaltung des Wechselrichters (1) auslöst, und der Abschaltzeitpunkt (t_{A}) des Wechselstroms (I_{AC}) oder der Wechselspannung (V_{AC}) ermittelt wird, woraus aus der Differenz zwischen dem Abschaltzeitpunkt (t_{A}) und dem zweiten Zeitpunkt (t_{F}) eine Abschaltzeitdauer (t_{Z}) des Wechselrichters (1) ermittelt wird.

## Beschreibung

Die gegenständliche Erfindung betrifft ein Verfahren zum Durchführen eines Abschalttests an einem Wechselrichter, der einen Wechselstrom und eine Wechselspannung am Ausgang erzeugt. Die Erfindung betrifft auch eine Anordnung zum Durchführen eines Abschalttests an einem Wechselrichter, mit einer Steuereinheit, die eine Schaltanordnung des Wechselrichters zur Erzeugung eines Wechselstrom und einer Wechselspannung am Ausgang ansteuert.

Wechselrichter werden verwendet, um eine elektrische Energiequelle zur Netzeinspeisung mit einem elektrischen Versorgungsnetz zu verbinden. Im Fall bidirektionaler Wechselrichter auch, um einen elektrischen Energiespeicher aus der Energiequelle oder aus dem Versorgungsnetz zu laden. Im Fall von notstromfähigen Wechselrichtern kann dieser die gespeicherte Energie auch ohne Versorgungsnetz Verbrauchern zur Verfügung stellen. Die elektrische Energiequelle ist beispielsweise eine Photovoltaikanlage oder eine oder mehrere Photovoltaikzelle(n). Die elektrische Energiequelle kann aber auch eine Windkraftanlage, eine Batterie oder ähnliches sein. Solche an einem Versorgungsnetz angeschlossene Wechselrichter unterliegen strengen Reglementierungen, beispielsweise von den nationalen Netzbetreibern oder durch nationale Gesetzgebung. Für die Zulassung eines Wechselrichters für den Netzbetrieb muss ein solcher Wechselrichter verschiedene Prüfverfahren durchlaufen. Viele dieser Prüfungen zielen darauf ab, dass der Wechselrichter nach einer definierten maximalen Zeit nach dem Eintreten eines Fehlers den Einspeisebetrieb beenden muss und/oder sich selbst vom Versorgungsnetz trennen muss. Der Wechselrichter hat somit Überwachungsfunktionen implementiert, um verschiedene Fehlersignale zu detektieren und auszuwerten und gegebenenfalls den Wechselrichter vom Versorgungsnetz oder den Lasten zu trennen. Bei den durchzuführenden Zulassungsprüfungen wird ein Fehlersignal auf den Ausgang des Wechselrichters geschaltet, das vom Wechselrichter zu detektieren ist und es sind in der Regel die Abschaltzeitdauer und der Messwert, bei dem sich der Wechselrichter vom Versorgungsnetz getrennt hat oder den Einspeisebetrieb beendet hat, zu ermitteln. Damit soll die in der Prüfnorm festgeschriebene maximale Abschaltzeitdauer verifiziert werden. Ein Problem in diesem Zusammenhang ist festzustellen, zu welchem Zeitpunkt das Fehlersignal angelegt wurde, um die vom Anlegen bis zur Abschaltung vergangene Zeit genau bestimmen zu können.

Bisher wurde entweder vom Wechselrichter an einem Triggerausgang ein Triggersignal ausgegeben, sobald das Fehlersignal bereitgestellt wurde. Das Triggersignal konnte dann erfasst werden, um davon ausgehend die Abschaltzeitdauer zu erfassen. Der Triggerausgang ist jedoch nur intern zugänglich, da dieser Ausgang im normalen Betrieb nicht benötigt wird. Damit muss der Wechselrichter zum Abgreifen des Triggersignals geöffnet werden, was aufgrund der hohen Spannungen im Wechselrichter problematisch ist und ein Sicherheitsrisiko darstellt. Nachdem das Triggersignal sehr zeitkritisch ist, werden hierfür sehr hardwarenahe I/Os benötigt, die dann meistens mit gefährlichem Potential (Spannungen größer der Kleinschutzspannung von 50V) behaftet sind oder sich im Umfeld von gefährlichem Potential befinden, was ebenfalls problematisch bei der Durchführung von Abschalttests ist, weil entsprechende Sicherheitsvorkehrungen getroffen werden müssen. Zusätzlich muss dazu an der Hardware des Wechselrichters ein eigener Triggerausgang vorgesehen sein, was natürlich die Schaltung aufwendiger und teurer macht.

Eine andere bekannte Methode ist die Verwendung eines hoch auflösenden Oszilloskops, um die relevanten Signale aufzunehmen. Allerdings stellt es bei sehr kleinen Änderungen der Spannung oder des Stromes ein erhebliches Problem dar, aufgrund der Messauflösung einen korrekten Trigger zu setzen. Dazu musste man oftmals sehr hochwertige Oszilloskope verwenden, was die Prüfung wiederum teuer macht.

Es ist daher eine Aufgabe der Erfindung eine Anordnung und ein Verfahren anzugeben, mit denen für eine Abschaltprüfung an einem Wechselrichter ohne zusätzlichen Hardwareaufwand oder ohne zusätzliche teure Messmittel eine exakte Triggerung des Zeitpunktes des Fehlereintritts ermittelt werden kann, um eine einfache Ermittlung der Abschaltzeitdauer zu ermöglichen.

Diese Aufgabe wird erfindungsgemäß gelöst, indem zu einem ersten Zeitpunkt ein Triggersignal auf den Wechselstrom oder die Wechselspannung aufmoduliert wird, mit dem Wechselrichter an einem zweiten Zeitpunkt eine definierte Zeitdauer nach dem Beginn des Triggersignals zum ersten Zeitpunkt mit dem Wechselrichter ein Wechselstrom oder eine Wechselspannung mit einem Fehlersignal erzeugt wird, das vom Wechselrichter erkannt wird und eine Abschaltung des Wechselrichters auslöst, und der Abschaltzeitpunkt des Wechselstroms oder der Wechselspannung ermittelt wird, woraus aus der Differenz zwischen dem Abschaltzeitpunkt und dem zweiten Zeitpunkt eine Abschaltzeitdauer des Wechselrichters ermittelt wird. Diese Aufgabe wird auch dadurch gelöst, dass die Steuereinheit die Schaltanordnung an einem ersten Zeitpunkt ansteuert, um ein Triggersignal auf den Wechselstrom oder die Wechselspannung aufzumodulieren, die Steuereinheit die Schaltanordnung an einem zweiten Zeitpunkt, eine definierte Zeitdauer nach dem Beginn des Triggersignals zum ersten Zeitpunkt, ansteuert, um einen Wechselstrom oder eine Wechselspannung mit einem Fehlersignal zu erzeugen, im Wechselrichter eine Sicherheitsfunktion implementiert ist, die das Fehlersignal erkennt und eine Abschaltung des Wechselrichters auslöst, und eine Auswerteeinheit vorgesehen ist, die den Abschaltzeitpunkt des Wechselstroms oder der Wechselspannung ermittelt, und aus der Differenz zwischen dem Abschaltzeitpunkt und dem zweiten Zeitpunkt eine Abschaltzeitdauer des Wechselrichters ermittelt.

Nach dem Start des Abschalttest zum ersten Zeitpunkt wird somit eine definierte Zeitdauer gewartet, bevor das Fehlersignal angelegt wird. Durch das Triggersignal kann der erste Zeitpunkt aber exakt und eindeutig bestimmt werden. Nachdem die Zeitdauer bekannt ist, kann auch eindeutig der zweite Zeitpunkt, an dem mit der Ausgabe des Fehlersignals begonnen wird, festgelegt werden. Der Abschaltzeitpunkt ist ebenfalls eindeutig als der Zeitpunkt feststellbar, an dem der Wechselstrom oder die Wechselspannung Null oder im Wesentlichen Null ist. Somit kann mit diesem Vorgehen die Abschaltzeitdauer, also die Zeit die zwischen dem Beginn des Fehlersignals und dem Abschalten vergeht, als Ergebnis des Abschalttests eindeutig und einfach ermittelt werden. Das Abschalten kann dabei beliebig erfolgen, beispielsweise durch das Öffnen von Trennstellen im Wechselrichter und/oder durch das Beenden des Erzeugens eines Wechselstromes / einer Wechselspannung. Das Abschalten kann auch beliebig ausgelöst werden, beispielsweise von der Steuereinheit des Wechselrichters.

Vorzugsweise wird der vom Wechselrichter erzeugte Wechselstrom oder die vom Wechselrichter erzeugte Wechselspannung gemessen und ausgewertet, um den ersten Zeitpunkt und/oder den Abschaltzeitpunkt zu ermitteln. Das erlaubt eine automatisierte Durchführung des Abschalttest, was den Abschalttest vereinfacht.

Eine weitere Vereinfachung, insbesondere der Ermittlung der verschiedenen Zeitpunkte, ergibt sich, wenn der erste Zeitpunkt und/oder der zweite Zeitpunkt auf einen Nulldurchgang des Wechselstromes oder der Wechselspannung synchronisiert werden.

In einer einfachen Ausgestaltung kann die Auswerteeinheit als Oszilloskop ausgeführt sein, das den Wechselstrom oder die Wechselspannung aufzeichnet, woraus der erste Zeitpunkt und/oder der Abschaltzeitpunkt ermittelbar sind.

Die gegenständliche Erfindung wird nachfolgend unter Bezugnahme auf die Figuren 1 bis 4 näher erläutert, die beispielhaft, schematisch und nicht einschränkend vorteilhafte Ausgestaltungen der Erfindung zeigen. Dabei zeigt
Fig.1 ein Ausführungsbeispiel eines Wechselrichters,
Fig.2 eine mögliche Anordnung zur Durchführung eines Abschalttests an einem Wechselrichter und
Fig.3 und 4 mögliche Ausführungen zum Triggern des Fehlersignals.

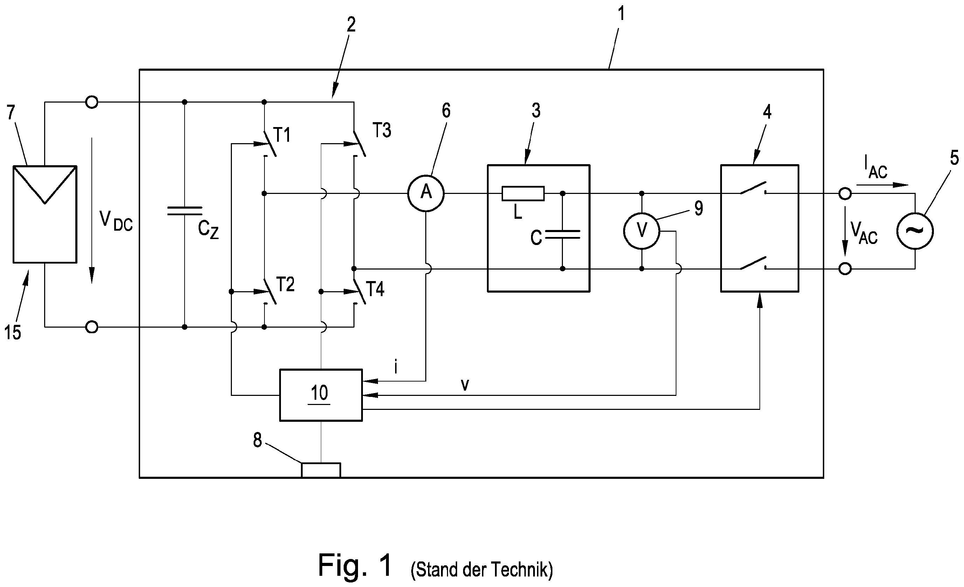

Fig.1 zeigt beispielhaft einen einphasigen Wechselrichter 1 mit einer Gleichspannungsseite mit Anschlussklemmen für eine Gleichspannung V_{DC} und einer Wechselspannungsseite mit Anschlussklemmen für eine Wechselspannung V_{AC}. An die Anschlussklemmen für eine Gleichspannung V_{DC} ist eine Gleichspannungsquelle als elektrische Energiequelle 15, beispielsweise zumindest ein Photovoltaikmodul 7, angeschlossen und über die Anschlussklemmen für eine Wechselspannung V_{AC} ist der Wechselrichter 1 mit einem elektrischen Versorgungsnetz 5, oder auch einer anderen elektrischen Last, verbunden.

Parallel zu den Anschlussklemmen für die Gleichspannung V_{DC} ist üblicherweise ein Gleichspannungszwischenkreiskondensator C_{Z} geschaltet, um die Gleichspannung V_{DC} zu glätten und zu stabilisieren. Wechselspannungsseitig kann vor den Anschlussklemmen für die Wechselspannung V_{AC} eine Trennstelle 4, beispielsweise mit Trennrelais, vorgesehen sein, um den Wechselrichter 1 vom Versorgungsnetz 5 trennen zu können. Vor der Trennstelle 4 kann ein Ausgangsfilter 3, beispielsweise mit einer Filterdrossel L und einer Filterkapazität C, geschaltet sein, um die erzeugte Wechselspannung V_{AC} zu glätten. Auch gleichspannungsseitig kann eine Trennstelle vorgesehen sein. Die Gleichspannungsseite des Wechselrichters 1 ist über eine Schaltanordnung 2, beispielsweise eine Brückenschaltung mit Halbleiterschalter T1, T2, T3, T4 mit der Wechselspannungsseite verbunden. Durch getaktetes Schalten der Halbleiterschalter T1, T2, T3, T4 der Schaltanordnung 2 wird in bekannter Weise die gewünschte Wechselspannung in Frequenz, Betrag und Phase erzeugt. Dabei synchronisiert sich der Wechselrichter 1 üblicherweise auf die Netzspannung im Versorgungsnetz 5.

Der Wechselrichter 1 kann auch mehrphasig ausgeführt sein, wobei die Schaltanordnung 2 und gegebenenfalls der Ausgangsfilter 3 und die Trennstelle 4 für jede Phase vorgesehen ist bzw. eine entsprechende Topologie der Schaltanordnung 2 verwendet wird.

Jeder Wechselrichter 1 hat auch eine Steuereinheit 10 (Hardware und Software) zum richtigen Ansteuern der Halbleiterschalter T1, T2, T3, T4 der Schaltanordnung 2. Die Steuereinheit 6 steuert auch die gleichspannungs- und/oder wechselspannungsseitige Trennstelle 4, um die Erzeugung der Wechselspannung V_{AC} oder analog des Wechselstroms I_{AC} zu beenden oder um den Wechselrichter 1 vom Versorgungsnetz 5 zu trennen. Der Wechselrichter 1 hat üblicherweise auch eine Ein-/Ausgabeschnittstelle 8, beispielsweise um Steuerbefehle von extern zu erhalten. Zur Steuerung des Wechselrichters 1 sind wechselspannungsseitig üblicherweise an geeigneter Stelle auch eine Spannungsmesseinheit 9 und eine Strommesseinheit 6 vorgesehen. Die erfassten Messgrößen werden in der Steuereinheit 10 zum Steuern des Wechselrichters 1 verarbeitet. Es kann auch gleichspannungsseitig eine Spannungsmesseinrichtung zum Messen der Zwischenkreisspannung vorgesehen sein, die ebenfalls in der Steuereinheit 10 verarbeitet werden kann.

Es sei aber angemerkt, dass es auch andere Topologien von Wechselrichtern 1 gibt, beispielsweise mit galvanischer Trennung der Gleichspannungsseite und der Wechselspannungsseite mittels eines Transformators oder mit einer anders ausgeführten Schaltanordnung 2, was aber für die gegenständliche Erfindung unerheblich ist. Das Ausführungsbeispiel nach Fig.1 dient lediglich der Erläuterung der Erfindung.

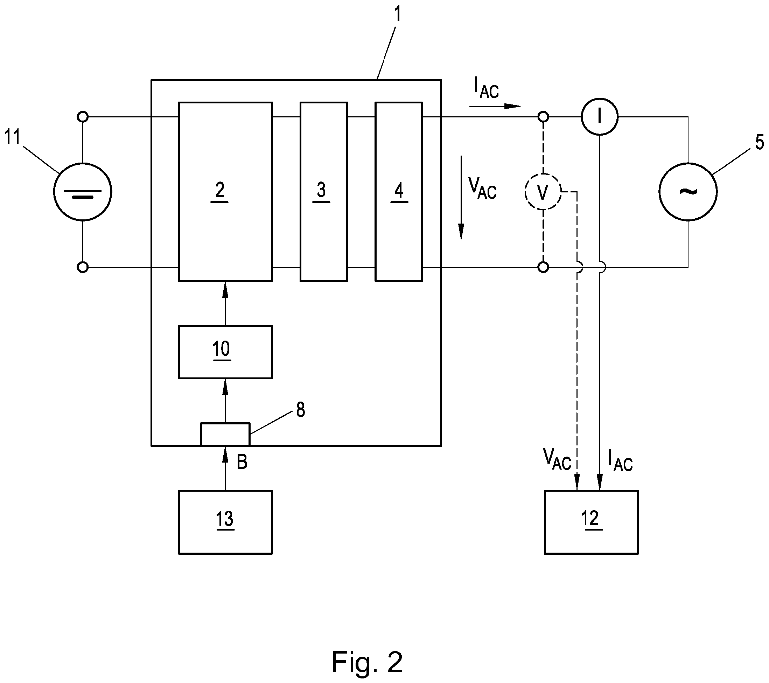

Zum Durchführen von Abschalttests am Wechselrichter 1 wird dieser üblicherweise im Laborumfeld von einer Gleichspannungsquelle 11 mit elektrischer Energie versorgt und an ein Versorgungsnetz 5, oder an eine andere elektrische Last, angeschlossen, wie in Fig.2 dargestellt. Ausgangsseitig wird der Wechselstrom I_{AC}, oder auch die Wechselspannung V_{AC} (wie strichliert angedeutet), messtechnisch erfasst und in einer Auswerteeinheit 12 (Hardware und/oder Software) ausgewertet. Von einer Prüfsteuereinheit 13 erhält der Wechselrichter 1 über die Ein-/Ausgabeschnittstelle 8 den Befehl B zur Durchführung eines Abschalttests. In welcher Art und Weise der Befehl B gegeben wird hängt natürlich von der Implementierung des Wechselrichter 1 und der Ein-/Ausgabeschnittstelle 8 ab, ist für die gegenständliche Erfindung jedoch unerheblich. Beispielsweise kann die Ein-/Ausgabeschnittstelle 8 als Busschnittstelle zu einem Datenkommunikationsbus, wie beispielsweise ein CAN-Bus oder Ethernet, implementiert sein. In diesem Fall wird der Befehl B beispielsweise als Busnachricht an den Wechselrichter 1 gesendet. Die Auswerteeinheit 12 und die Prüfsteuereinheit 13 können auch auf einer gemeinsamen Hardware ausgeführt sein. Es kann aber auch vorgesehen sein, dass ein Abschalttest direkt an der Ein-/Ausgabeschnittstelle 8, beispielsweise ein Touchscreen mit entsprechender Menüführung, auswählbar ist und der Befehl B direkt an der Ein-/Ausgabeschnittstelle 8, beispielsweise von einem Benutzer, gegeben wird. In diesem Fall kann auch vorgesehen sein, dass der Benutzer in das Menü für den Abschalttest nur durch vorherige Eingabe eines geheimen Sicherheitscodes oder Drücken einer geheimen Tastenkombination, oder ähnliches, gelangt, damit diese Funktionalität im normalen Betrieb nicht zugänglich ist.

Mit dem Befehl B kann auch die Art des Abschalttests übermittelt werden. Beispielsweise kann der Abschalttest zur Detektion eines Gleichanteils im Wechselstrom I_{AC} als Fehlersignal durchgeführt werden. Dabei kann mit dem Befehl auch der einzustellende Wert des Fehlersignals, beispielsweise der Wert des Gleichanteils, übermittelt werden. Andere typische Abschalttest sind Überspannung, Über-/Unterfrequenz, erkannte Inselnetze, Lichtbögen, etc. Das Fehlersignal, und der Wechselstrom I_{AC}, wird durch die Schaltanordnung 2 erzeugt, indem die Schaltanordnung 2 von der Steuereinheit 10 in geeigneter Weise angesteuert wird. Im Wechselrichter 1 ist eine Sicherheitsfunktion implementiert, vorzugsweise in der Steuereinheit 10 oder einer separaten Sicherheitseinheit, die den Wechselstrom I_{AC}, oder auch die Wechselspannung V_{AC}, auf mögliche Fehlersignale auswertet, beispielsweise anhand der im Wechselrichter 1 gemessenen Spannung v und/oder dem gemessenen Strom i. Wird ein Fehlersignal erkannt, muss sich der Wechselrichter 1 selbststätig vom Versorgungsnetz 5 trennen, beispielsweise über die Trennstelle 4 oder einer gleichspannungsseitigen Trennstelle, oder die Erzeugung der Wechselspannung V_{AC} / des Wechselstroms I_{AC} beenden.

In der Steuereinheit 10 ist eine Prüfroutine implementiert, beispielsweise als Software auf einer Steuereinheit-Hardware, die bei Erhalt des Befehls B gestartet wird. Die Prüfroutine erzeugt nun vor dem Erzeugen des Fehlersignals einen auf den Wechselstrom I_{AC}, oder die Wechselspannung V_{AC}, aufmoduliertes Triggersignal TS mit einer vorgegebenen Frequenz und Amplitude. Die Frequenz kann dabei maximal die halbe Taktfrequenz (typischerweise im Bereich größer 20kHz) der Schaltanordnung 2 betragen. Das Triggersignal TS soll dabei natürlich einfach und eindeutig identifizierbar sein und soll das Versorgungsnetz 5 möglichst wenig beeinflussen. Beispielsweise ist das Triggersignal TS ein Wechselsignal mit einer Frequenz im Bereich von der hundert- bis tausendfachen Netzfrequenz, beispielsweise eine Frequenz von 1 kHz, mit einer Amplitude im Zehntelbereich der Amplitude des Wechseltroms I_{AC}, beispielsweise 0.3A-0.5 A, oder im Hunderstelbereich der Amplitude der Wechselspannung V_{AC}, beispielsweise 3V-10V bei 230V Netzspannung. Ein solches Triggersignal kann einfach im Wechselstrom I_{AC}, oder in der Wechselspannung V_{AC}, erkannt werden, sowohl durch Messen und Auswerten, aber auch auf einem einfachen Oszilloskop ohne besondere Anforderung an die Auflösung. Das Triggersignal TS ist dabei vorzugsweise auf den Wechselstrom I_{AC}, die Wechselspannung V_{AC}, synchronisiert, sodass das Triggersignal beispielsweise an einem Nulldurchgang des Wechselstroms I_{AC}, der Wechselspannung V_{AC}, beginnt und für eine bestimmte Periodendauer andauert, beispielsweise x Halbwellen des Wechselstroms I_{AC}, der Wechselspannung V_{AC}, mit x≥1. Das Triggersignal TS muss aber nicht zwingend synchronisiert sein, sondern kann grundsätzlich zu einer beliebigen Zeit beginnen und eine vorgegebene Zeit andauern.

Das Triggersignal TS wird durch entsprechendes Ansteuern der Schaltanordnung 2 durch die Steuereinheit 10 erzeugt und dient der Ankündigung des darauf folgenden Fehlersignals FS. Dabei kann die Zeitmessung bis zum Start des Fehlersignals FS vom Start des Triggersignals TS, als auch vom Ende des Triggersignals TS ausgehen. Wenn das Triggersignal TS eine definierte Dauer hat, dann wird vorzugsweise das Ende des Triggersignals TS als Trigger T für das Fehlersignal FS verwendet. Wenn das Triggersignal TS jedoch keine definierte Dauer hat, beispielsweise wenn als Triggersignal TS ein Puls ohne definiertem Ende auf die Wechselspannung V_{AC} geschaltet wird, dann wird vorzugsweise der Anfang des Triggersignals TS als Trigger T für das Fehlersignal FS verwendet und das Fehlersignal FS nach einer definierten Zeitdauer t_{D}≥0 nach dem Trigger T gestartet. Das Fehlersignal FS beginnt somit eine definierte Zeitdauer t_{D} nach dem Trigger T durch das Triggersignal TS. Beide Methoden sind aber natürlich gleichwertig.

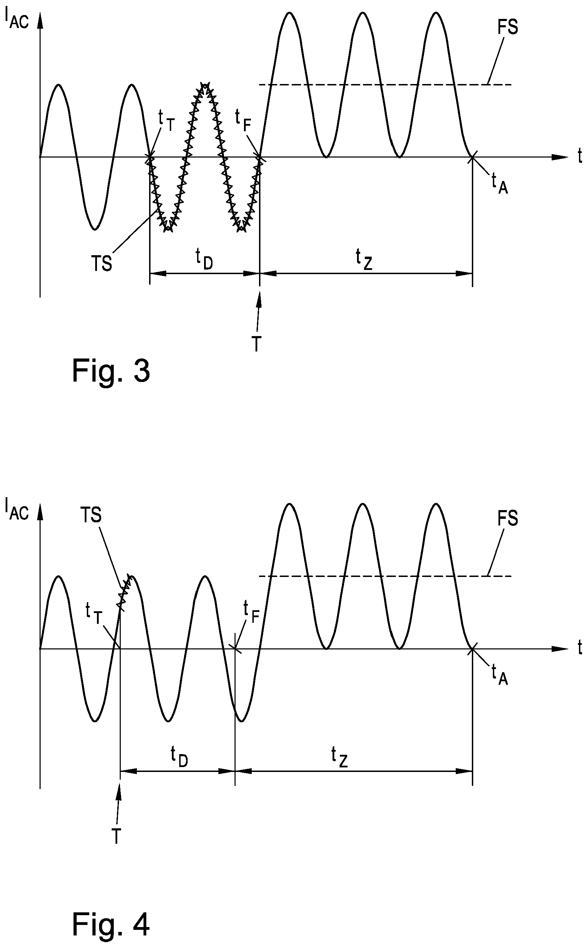

Das ist beispielhaft in Fig.3 am Beispiel des Wechselstromes I_{AC} (Wechselspannung V_{AC} ist natürlich analog) dargestellt. Bis zu einem Zeitpunkt t_{T} liegt der vom Wechselrichter 1 erzeugte Wechselstrom I_{AC} am Ausgang an, welcher in das Versorgungsnetz 5 eingespeist wird. Zum ersten Zeitpunkt t_{T} an einen Nulldurchgang des Wechselstroms I_{AC} wird dem Wechselstrom I_{AC} ein Triggersignal TS aufmoduliert, hier beispielsweise ein Wechselsignal mit 1kHz und 0.5A und einer vorgegebenen Zeitdauer t_{D} von drei Halbwellen. Der Trigger T für das Fehlersignal FS ist damit drei Halbwellen nach dem Zeitpunkt t_{T} zum zweiten Zeitpunkt t_{F} festgelegt. Das Fehlersignal FS, beispielsweise ein Gleichanteil im Wechselstrom I_{AC} (wie in Fig.3), oder z.B. auch eine Frequenzänderung, eine Amplitudenänderung oder eine Kombination daraus, beginnt damit zum definierten Zeitpunkt t_{F}(t_{T} + t_{D}).

Im Ausführungsbeispiel nach Fig.4 wird zum ersten Zeitpunkt t_{T} ein Puls auf den Wechselstrom I_{AC} aufmoduliert. Bis zum Zeitpunkt t_{T} liegt also der vom Wechselrichter 1 erzeugte Wechselstrom I_{AC} am Ausgang an, welcher in das Versorgungsnetz 5 eingespeist wird. Der detektierbare Beginn des Pulses zum Zeitpunkt t_{T} wird als Trigger T verwendet, wobei der Zeitpunkt t_{T} in diesem Beispiel nicht auf den Wechselstrom I_{AC} synchronisiert ist, sondern ein beliebiger Zeitpunkt ist. Nach einer definierten Zeitdauer t_{D} beginnt das Fehlersignal FS, beispielsweise ein Gleichanteil auf dem Wechselstrom I_{AC}, zum definierten zweiten Zeitpunkt t_{F}(t_{T} + t_{D}).

Mit Bezugnahme auf die Fig. 3 und 4 wird nun im Detail die Zeitmessung ab dem Zeitpunkt t_{F} beschrieben.

Demnach startet die Zeitmessung mit dem Fehlersignal FS zum Zeitpunkt t_{F} und endet zu einem Zeitpunkt t_{A}, an dem der Wechselrichter 1 vom Versorgungsnetz 5, oder der Last, getrennt wurde oder die Erzeugung des Wechselstromes I_{AC} / der Wechselspannung V_{AC} beendet wurde. Das Fehlersignal FS ist dabei ein Gleichanteil, womit beispielsweise ein Fehler eines Stromsensors im Wechselrichter 1 simuliert wird. Der Abschaltzeitpunkt t_{A}, an dem der Wechselrichter 1 am Ausgang vom Versorgungsnetz 5 getrennt wird, beispielsweise durch das Öffnen der Trennstelle 4, oder an dem die Erzeugung einer Wechselspannung V_{AC} / eines Wechselstrom I_{AC} beendet wird, beispielsweise durch die Steuereinheit 10, kann eindeutig festgestellt werden, indem ermittelt wird, ab wann der Wechselstrom I_{AC} / die Wechselspannung V_{AC} im Wesentlichen Null ist. Dabei kann geprüft werden, ob der Wechselstrom I_{AC} oder die Wechselspannung V_{AC} tatsächlich dauerhaft (um Nulldurchgänge zu unterscheiden) Null sind, oder dauerhaft innerhalb eines engen Fensters, beispielsweise ±0.3 A oder ±10 V um Null liegen. Die Zeitdifferenz zwischen dem Abschaltzeitpunkt t_{A} und dem Startpunkt des Fehlersignals t_{F} ergibt dann die mit dem Abschalttest zu prüfende Abschaltzeitdauer t_{Z} des Wechselrichters, welche mit der Auswerteeinheit 12 geprüft werden kann.

Die Zeitpunkte und Zeitdauern können durch Auswerten des mit der Auswerteeinheit 12 erfassten Wechselstroms I_{AC} / Wechselspannung V_{AC} ermittelt werden. Dazu kann der Wechselstrom I_{AC} oder die Wechselspannung V_{AC} wie in Fig.2 gemessen und in der Auswerteeinheit 12 ausgewertet werden. Die Auswerteeinheit 12 könnte aber auch als herkömmliches Oszilloskop ausgeführt sein, wobei keine Messeinheiten erforderlich wären, sondern der Wechselstrom I_{AC} / die Wechselspannung V_{AC} direkt abgegriffen werden könnten. Der Abschalttest kann durchgeführt werden, ohne den Wechselrichter 1 öffnen zu müssen, oder den Wechselrichter 1 hardwaremäßig anpassen zu müssen. Lediglich die Prüfroutine ist in der Steuereinheit 10 zu implementieren.

## Patentansprüche

1. Verfahren zum Durchführen eines Abschalttests an einem Wechselrichter (1), der einen Wechselstrom (I_{AC}) und eine Wechselspannung (V_{AC}) am Ausgang erzeugt, **dadurch gekennzeichnet, dass** zu einem ersten Zeitpunkt (t_{T}) ein Triggersignal (TS) auf den Wechselstrom (I_{AC}) oder die Wechselspannung (V_{AC}) aufmoduliert wird, **dass** mit dem Wechselrichter (1) an einem zweiten Zeitpunkt (t_{F}) eine definierte Zeitdauer (t_{D}) nach dem Beginn des Triggersignals (TS) zum ersten Zeitpunkt (t_{T}) mit dem Wechselrichter (1) ein Wechselstrom (I_{AC}) oder eine Wechselspannung (V_{AC}) mit einem Fehlersignal (FS) erzeugt wird, das vom Wechselrichter (1) erkannt wird und eine Abschaltung des Wechselrichters (1) auslöst, **und dass** der Abschaltzeitpunkt (t_{A}) des Wechselstroms (I_{AC}) oder der Wechselspannung (V_{AC}) ermittelt wird, woraus aus der Differenz zwischen dem Abschaltzeitpunkt (t_{A}) und dem zweiten Zeitpunkt (t_{F}) eine Abschaltzeitdauer (t_{Z}) des Wechselrichters (1) ermittelt wird.

2. Verfahren nach Anspruch 1, **dadurch gekennzeichnet, dass** der vom Wechselrichter (1) erzeugte Wechselstrom (I_{AC}) oder die vom Wechselrichter (1) erzeugte Wechselspannung (V_{AC}) gemessen und ausgewertet wird, um den ersten Zeitpunkt (t_{T}) und/oder den Abschaltzeitpunkt (t_{A}) zu ermitteln.

3. Verfahren nach Anspruch 1 oder 2, **dadurch gekennzeichnet, dass** der erste Zeitpunkt (t_{T}) auf einen Nulldurchgang des Wechselstromes (I_{AC}) oder der Wechselspannung (V_{AC}) synchronisiert wird.

4. Verfahren nach Anspruch 3, **dadurch gekennzeichnet, dass** der zweite Zeitpunkt (t_{F}) auf einen Nulldurchgang des Wechselstromes (I_{AC}) oder der Wechselspannung (V_{AC}) synchronisiert wird.

5. Anordnung zum Durchführen eines Abschalttests an einem Wechselrichter (1), mit einer Steuereinheit (10), die eine Schaltanordnung (2) des Wechselrichters (1) zur Erzeugung eines Wechselstrom (I_{AC}) und einer Wechselspannung (VAC) am Ausgang ansteuert, **dadurch gekennzeichnet, dass** die Steuereinheit (10) die Schaltanordnung (2) an einem ersten Zeitpunkt (t_{T}) ansteuert, um ein Triggersignal (TS) auf den Wechselstrom (I_{AC}) oder die Wechselspannung (V_{AC}) aufzumodulieren, **dass** die Steuereinheit (10) die Schaltanordnung (2) an einem zweiten Zeitpunkt (t_{F}), eine definierte Zeitdauer (t_{D}) nach dem Beginn des Triggersignals (TS) zum ersten Zeitpunkt (t_{T}), ansteuert, um einen Wechselstrom (I_{AC}) oder eine Wechselspannung (V_{AC}) mit einem Fehlersignal (FS) zu erzeugen, **dass** im Wechselrichter (1) eine Sicherheitsfunktion implementiert ist, die das Fehlersignal (FS) erkennt und eine Abschaltung des Wechselrichters (1) auslöst, **und dass** eine Auswerteeinheit (12) vorgesehen ist, die den Abschaltzeitpunkt (t_{A}) des Wechselstroms (I_{AC}) oder der Wechselspannung (V_{AC}) ermittelt, und aus der Differenz zwischen dem Abschaltzeitpunkt (t_{A}) und dem zweiten Zeitpunkt (t_{F}) eine Abschaltzeitdauer (t_{Z}) des Wechselrichters (1) ermittelt.

6. Anordnung nach Anspruch 5, **dadurch gekennzeichnet, dass** eine Messeinrichtung zum Messen des vom Wechselrichter (1) erzeugten Wechselstromes (I_{AC}) oder der vom Wechselrichter (1) erzeugten Wechselspannung (V_{AC}) vorgesehen ist und die Auswerteeinheit (12) den gemessenen Wechselstrom (I_{AC}) oder die gemessene Wechselspannung (V_{AC}) zur Ermittlung des ersten Zeitpunktes (t_{T}) und/oder des Abschaltzeitpunktes (t_{A}) auswertet.

7. Anordnung nach Anspruch 5 , **dadurch gekennzeichnet, dass** die Auswerteeinheit (12) als Oszilloskop ausgeführt ist, das den Wechselstrom (I_{AC}) oder die Wechselspannung (V_{AC}) aufzeichnet, woraus der erste Zeitpunkt (t_{T}) und/oder der Abschaltzeitpunkt (t_{A}) ermittelbar ist.
